# EUROPEAN PATENT APPLICATION

(11) **EP 4 481 803 A1**
(43) Date of publication of application: **25.12.2024**
(21) Application number: 23181138.1
(22) Date of filing: 23.06.2023
(51) Int. Cl.: H01L 23/00, H01L 21/56, H01L 23/31, H01L 23/495

(54) **SEMICONDUCTOR DIE PACKAGE AND METHOD**

(71) Applicant: Nexperia B.V., 6534 AB Nijmegen (NL)
(72) Inventor: Yandoc, Ricardo, Manchester, SK7 5BJ (GB); Pandey, Deepak Chandra, Manchester (GB)
(74) Representative: Pjanovic, Ilija

(57) **Abstract**

There is provided a method of manufacturing a manufacturing intermediate for a semiconductor package, the method comprising: providing a die; at least partially encapsulating the die within a moulding compound; and thinning the die. There is further provided a manufacturing intermediate for a semiconductor package, comprising: a die having a first surface and a second surface; and a moulding encapsulating the die; in which the first surface of the die is exposed.

## Description

The present invention provides a manufacturing intermediate for a semiconductor die package and a method of manufacturing the same. The present invention further provides a semiconductor die package comprising the manufacturing intermediate and a method of manufacturing the same.

Semiconductors are devices that are used within electronic circuitry. An individual semiconductor device is known as a die. To enable semiconductor dies to integrate within electronic circuitry, semiconductors dies are typically provided in a housing, known as a die package. Such die packages typically encapsulate the semiconductor die within a block of insulating material, such as plastic.

Semiconductor dies manufactured are from a semiconductor wafer. The wafer is typically a circular disc that is around 200 mm in diameter (although larger and smaller wafers are possible). The semiconductor circuitry is fabricated onto the wafer using known processes. Once fabrication is complete, the wafer can be broken down into individual dies. Each die is typically of the order of around 6 mm by around 6 mm in size, although larger and smaller dies are of course possible.

In order to provide sufficient mechanical strength to the wafer during etching, the wafer is typically provided with a thickness of around 600 µm to around 750 µm. However, during use, the semiconductor dies will exhibit an internal electrical resistance that is proportional to its thickness. Typically, electrical resistance will increase by around 10% for each 25 µm of die thickness. Therefore, it is preferable for the die to be manufactured so that it is as thin as possible.

It is known to thin the dies by grinding the rear surface of the wafer before the wafer is divided into individual dies. Typically, the wafer is thinned to a thickness of less than around 100 µm, or potentially as low as around 50 µm or around 25 µm. However, when the wafer is thinned to this extent it loses mechanical strength. Internal material stresses and outside environmental factors may therefore cause the wafer to warp (i.e. bow upwards or downwards). In some circumstances, this can lead to crack formation and material failure rendering the wafer unusable.

In order to mitigate this, it is known to provide the wafer with a so-called "Taiko ring". To form a Taiko ring, the radial dimension of the wafer is sized so that it is larger than the etching zone. Only the central portion of the wafer is thinned by grinding, leaving an annular ring of non-thinned material surrounding the thinned portion of the wafer. However, the central portion of the wafer remains extremely fragile. Therefore, whilst Taiko rings are able to substantially reduce wafer warpage and breakage, they do not eliminate such problems entirely.

Moreover, regardless of whether or not a Taiko ring is used, once the individual dies are cut from the wafer, each die is fragile and difficult to handle. In particular, the mechanical behaviour of an individual die is somewhat akin to a thin piece of paper, and is prone to warping, crinkling, folding, tearing etc.

It is an object of the present invention to provide a manufacturing intermediate for a semiconductor die package and a method of manufacturing the same that obviates or mitigates against the problem of warpage and breakage of semiconductor wafers and/or dies.

According to a first aspect of the invention, there is provided a method of manufacturing a manufacturing intermediate for a semiconductor package, the method comprising: providing a die; at least partially encapsulating the die within a moulding compound; and thinning the die.

Because the die is encapsulated within a moulding compound, this provides mechanical strength to the die during thinning. Accordingly, it is possible to thin the die without causing warpage or breakage, as the die remains supported by the moulding compound during the thinning process. Once the thinning process is complete, the die will remain exposed on at least one side, thereby enabling it to be electrically connected to further components of the semiconductor die package.

The step of "thinning" comprises substantially any suitable thinning process. In particular, this may comprise abrading the die. Suitable abrasion processes for this purpose include grinding and/or polishing.

The term "manufacturing intermediate for a semiconductor package" encompasses the assembly of a selection of sub-components of a semiconductor package, including at least a semiconductor die, into a sub-assembly. The sub-assembly may subsequently be assembled with other components to form a complete semiconductor package that can be handled by an operator and installed into an electronic circuit. In particular, the "manufacturing intermediate" may be a unitary structure formed by the encapsulation of the die and any other components within the moulding compound.

The die may define a first surface and a second surface and the method may further comprise: providing a base frame having a first surface and a second surface; attaching the first surface of the die to the first surface of the base frame; wherein the step of at least partially encapsulating the die within a moulding compound comprises at least partially encapsulating the base frame and the die within the moulding compound; and removing the base frame to expose the first surface of the die.

The provision of a base frame enables the die to be supported during the encapsulation process. Therefore, the die is easier to handle. In addition, the base frame may enable other components of the manufacturing intermediate to be mounted in any required positions or orientations before the encapsulation process.

As used throughout this disclosure, a step of "attaching" may comprise any suitable method of attachment. For example, this may comprise adhering, and in particular adhering by soldering.

By exposing the first surface of the die, this enables the die to be thinned. In practice, the steps of removing the base frame and thinning the die may be carried out during the same process. For example, a single abrasion process may be used that entirely abrades the base frame to expose the die and then continues to thin the die.

Removing the base frame may comprise any suitable removal process. For example, this may comprise abrading the base frame by grinding, polishing or the like. Alternatively, the base frame may be frangibly separated from the die, or may be chemically separated from the die.

The step of at least partially encapsulating the base frame and the die within the moulding compound may comprise leaving the second surface of the base frame exposed. Because the second surface of the base frame is exposed, this enables the base frame to be removed more easily. For example, it is possible to directly abrade the base frame using a grinding and/or polishing process.

The step of thinning the die may comprise thinning the die to at most around 100 µm, or preferably at most around 50 µm, or most more preferably at most around 25 µm, or most preferably at most around 15 µm. The thickness of the die is proportional to its internal electrical resistance. It has been found that thinning the die to at most around 100 µm, or preferably at most around 50 µm, or most more preferably at most around 25 µm, or most preferably at most around 15 µm minimises electrical resistance.

Prior to the step of thinning the die, the die may comprise a thickness of at least around 200 150 µm, or preferably at least around 500 µm, or most preferably at least around 600 to 700 µm.

Thinning the die may comprise abrading the die. That is to say, using an abrasion process to reduce the thickness of the die. The abrasion process may comprise any suitable abrasion process, such as for example grinding and/or polishing.

The method may further comprise: providing a clip having a first connection portion and a second connection portion; before the step of at least partially encapsulating the base frame and the die within a moulding compound: attaching the first connection portion of the clip to the second surface of the die; and attaching the second connection portion of the clip to the first surface of the base frame; and during the step of encapsulating the base frame and the die within a moulding compound: encapsulating the clip within the moulding compound. By encapsulating the clip within the moulding compound, the clip also adds mechanical strength to support the die during thinning. In such embodiments, the step of removing the base frame to expose the first surface of the die may further comprise exposing the second connection portion of the clip.

The method may further comprise: thinning the second connection portion of the clip. The second connection portion of the clip may be thinned by the same amount as the first connection portion.

The method may further comprise: providing a first plating to the first surface of the die; and providing a second plating to the second connection portion of the clip.

According to a second aspect of the invention, there is provided a method of manufacturing a semiconductor package comprising: providing a manufacturing intermediate according to the first aspect of the invention; providing a second base frame having a first portion and a second portion; attaching the first portion of the second base frame to the first plating; and attaching the second portion of the second base frame to the second plating. It will be appreciated that the method of manufacturing a semiconductor package according to the second aspect of the invention may comprise any of the steps of the method of manufacturing a manufacturing intermediate according to the first aspect of the invention.

The method may further comprise: at least partially encapsulating the manufacturing intermediate, first plating, second plating, and second base frame within a second moulding compound. The first moulding compound and the second moulding compound may be made from the same material.

According to a third aspect of the invention there is provided a manufacturing intermediate for a semiconductor package, comprising: a die having a first surface and a second surface; and a moulding encapsulating the die; wherein the first surface of the die is exposed.

Because the first surface of the die is exposed, this enables the die to be electrically connected to further components of the semiconductor package, such as for example a base frame defining one or more terminals of the semiconductor package. Additionally, because the die is encapsulated within the moulding, this provides strength to the die to enable it to be handled be an operator. The fact that the first surface of the die is exposed may also enable the dimensions of the die to be adjusted using a thinning process, and/or may be as a result of such a thinning process being carried out upon the die.

The die may comprise a thickness of at most around 100 µm, or preferably at most around 50 µm, or more preferably at most around 25 µm, or most preferably at most around 15 µm.

The manufacturing intermediate may further comprise: a clip having a first connection portion and a second connection portion; wherein: the clip is encapsulated within the moulding compound; the first connection portion is attached to the second surface of the die; and the second connection portion is exposed.

According to a fourth aspect of the invention, there is provided a semiconductor package comprising: the manufacturing intermediate of the second aspect of the invention; a first plating attached to the first surface of the die; a second plating attached to the second connection portion of the clip; a base frame comprising a first portion attached to the first plating and a second portion attached to the second plating; and a second moulding encapsulating the manufacturing intermediate, first plating, second plating, and base frame.

A detailed description of the invention is provided below with reference to the accompanying drawings, in which:
Figure 1 is a schematic cross-sectional view of a first step of a method of manufacturing a manufacturing intermediate according to the present invention;
Figure 2 is a schematic cross-sectional view of a second step in the method of manufacturing a manufacturing intermediate;
Figure 3 is a schematic cross-sectional view of a third step in the method of manufacturing a manufacturing intermediate;
Figure 4 is a schematic cross-sectional view of a fourth step in the method of manufacturing a manufacturing intermediate;
Figure 5 is a schematic cross-sectional view of a fifth step in the method of manufacturing a manufacturing intermediate;
Figure 6 is a schematic cross-sectional view of a sixth step in the method of manufacturing a manufacturing intermediate;
Figure 7 is a schematic cross-sectional view of a seventh step in the method of manufacturing a manufacturing intermediate;
Figure 8 is a schematic cross-sectional view of a eighth step in the method of manufacturing a manufacturing intermediate;
Figure 9 is a schematic cross-sectional view of a ninth step in the method of manufacturing a manufacturing intermediate;
Figure 10 is a schematic cross-sectional view of a first step in method of manufacturing a semiconductor package using the manufacturing intermediate arrived at by the method described in relation to Figures 1 to 9;
Figure 11 is a schematic cross-sectional view of a second step in the method of manufacturing a semiconductor package,
Figure 12 is a schematic process diagram of the method of manufacturing a manufacturing intermediate described in relation to Figures 1 to 9;
Figure 13 is a schematic process diagram of the method of manufacturing a manufacturing intermediate;
Figure 14 is a schematic process diagram of the method of manufacturing a manufacturing intermediate; and
Figure 15 is a schematic process diagram of the method of manufacturing a semiconductor package described in relation to Figures 10 and 11.

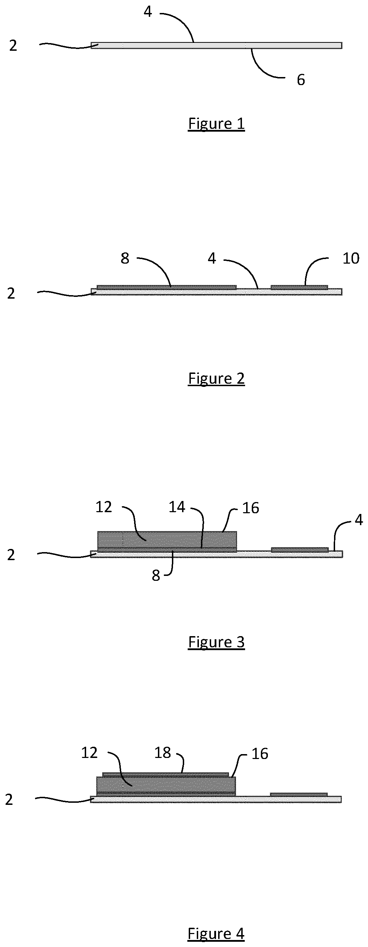

Figure 1 shows a first step of a process for manufacturing a manufacturing intermediate. In the first step, a base frame 2 is provided. The base frame 2 has a first surface 4 and a second surface 6. The base frame is made from any suitable material, and preferably from a metal, for example copper or the like.

Figure 2 shows a second step of the manufacturing method. In the second step, a first patch of adhesive 8 and a second patch of adhesive 10 are applied to the first surface 4 of the base frame 2. The adhesive may be any suitable adhesive, and is preferably a conductive adhesive, for example solder.

Figure 3 shows a third step of the manufacturing method. In the third step, a die 12 is provided. The die 12 comprises a first surface 14 and a second surface 16. The first surface 14 of the die 12 is attached to the first surface 4 of the base layer 2 via the first patch of adhesive 8.

Figure 4 shows a fourth step of the manufacturing method. In the fourth step, a third patch of adhesive 18 is applied to the second surface 16 of the die 12. Again, the adhesive may be any suitable adhesive, and is preferably a conductive adhesive, for example solder.

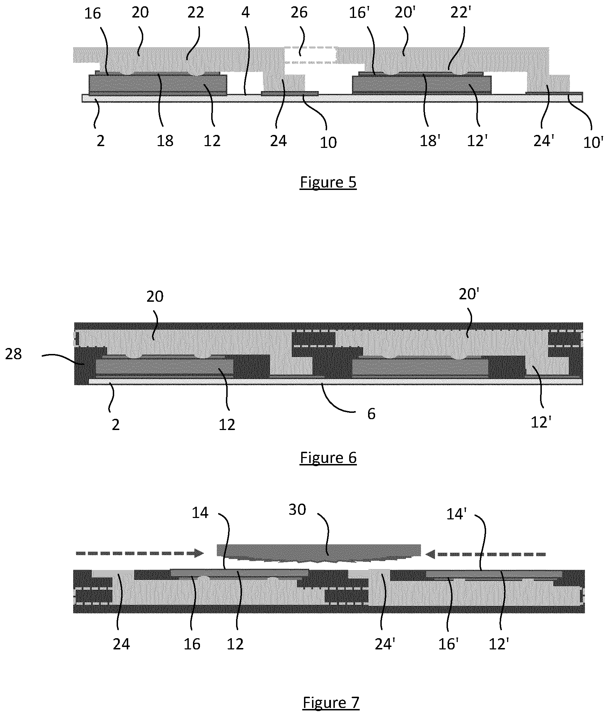

Figure 5 shows a fifth step of the manufacturing method. In the fifth step, a clip 20 is provided. The clip 20 comprises a first connection portion 22 and a second connection portion 24. The clip 20 is made from metal, preferably copper or the like. The first connection portion 22 of the clip 20 is attached to the second surface 16 of the die 12 via the third patch of adhesive 18. The second connection portion 24 of the clip 20 is attached to the first surface 4 of the base frame 2 via the second patch of adhesive 10.

Although the clip 20 is shown as comprising only two connection portions, it will be appreciated that in alternative embodiments the clip 20 may comprise any number of connection portions. In particular, it will be appreciated that the second and subsequent connection portions of the clip 20 may each be configured for attachment to a separate connection terminal that enables the eventual semiconductor package to be integrated into electronic circuitry. For example, the various connection portions of the clip 20 may form part of a conducting path defining the drain, source and/or gate terminals of the semiconductor package. Although only a single clip 20 is described above as being connected between the die 12 and the base frame 2, it will be appreciated that in alternative embodiments multiple clips 20 may be connected between a single (i.e. individual) die 12 and the base frame 2.

The clip 20 may be a single clip or a matrix of clips. In this sense, a single clip is a grouping of mutually inter-operable connection portions, forming a set of connections portions (such as the first connection portion 22 and the second connection portion 24), collectively configured to conduct electrical current between one or more parts of the die 12 and one or more connection terminals of the eventual semiconductor die package. A matrix clip is a component defining multiple sets of connection portions (such as the first connection portion 22 and the second connection portion 24) and configured so that each set of connection portions can be separated from one another later in the manufacturing method to define a series of single clips. Put another way, a matrix clip is a component comprising multiple clips 20, 20' separable into individual clips 20.

As shown on the right-hand side of Figure 5, when a matrix clip is used, this may enable a large number of manufacturing intermediates to be manufactured at one time on a single base frame 2. In particular, a matrix of (i.e. group of individual) manufacturing intermediates may be manufactured, which are then separated at a later stage, as described below. In Figure 5, the components of the additional manufacturing intermediates are denoted with the prime symbol. The matrix clip comprises multiple clip bodies 20, 20' joined by bridges 26.

Figure 6 shows a sixth step of the manufacturing method. In the sixth step, the base frame 2, die 12, and clip 20 are encapsulated in a moulding compound 28. The moulding compound 28 sets to a solid state. The moulding compound 28 may be any suitable moulding compound, such as for example silicone or epoxy resin, plastic or the like. Preferably, the second surface 6 of the base frame 2 should remain exposed following the encapsulation by the moulding compound 28. However, it will be appreciated that in alternative embodiments the base frame 2 maybe be fully encapsulated within the moulding compound 28. The encapsulation of the base frame 2, die 12, and clip 20 forms a unitary structure.

Figure 7 shows a seventh step of the manufacturing method. In the seventh step, the assembly is flipped over to place the base layer 2 on top. The base frame 2 is then removed by abrasion using a polisher / grinder 30 moving in a path denoted by the arrows. However, in alternative embodiments any suitable method of removing the base layer 2 may be used. For example, the base layer may be frangibly separated from the die 12 and moulding compound 28.

Following the removal of the base layer 2, the die 12 and the second connection portion 24 of the clip 20 are thinned. In the present embodiment, the die 12 and the second connection portion 24 of the clip 20 are thinned by abrasion using the polisher / grinder 30. However, in alternative embodiments any suitable thinning process may be used, such as for example chemical etching, laser ablation or the like.

Preferably, the die is thinned so that the thickness of the die (i.e. the dimension of the die between the first surface 14 and the second surface 16) is at most around 100 µm, or preferably at most around 50 µm, or more preferably at most around 25 µm, or most preferably at most around 15 µm. As explained above, the thinner the die 12, the lower the internal electrical resistance. Because the die 12 is encapsulated within the moulding compound 28, the die 12 is supported during the thinning process by the moulding compound 28. This support keeps the die 12 rigid and prevents the die 12 from deforming once thinned. Accordingly, the problems of die warpage and breakage associated with the prior art are almost entirely avoided.

It will be appreciated that the clip 20 also provides additional mechanical strength that provides further support to the die 12 and resists deformation of the die 12 so as to keep it rigid during the thinning process. However, it will be appreciated that it would be possible to adequately support the die 12 during the thinning process using only the support of the moulding compound 28, in the absence of any clip 20 or base frame 2.

It will be appreciated that, prior to the step of thinning, the die 12 was, of course, thicker. In particular, the thickness of the die 12 prior to the step of thinning may be the thickness of the silicon wafer from which the die was manufactured. Alternatively, the silicon wafer from which the die was manufactured may have been thinned by a certain extent before the die 12 was separated from the wafer. Regardless of which option above is chosen, the thickness of the die 12 before the step of thinning is normally at least around 150 µm, to 700 µm. The thicker the die 12 before the step of thinning, the greater the mechanical strength of the die 12.

In order to provide sufficient mechanical strength to support the die 12 during the thinning process, it is preferable that the moulding compound 28 defines a thickness that is at least 2 times the thickness of the die 12 before the step of thinning. In general, increasing the thickness of the moulding compound 28 and any encapsulated die 20 will provide better support to the die 12 during the thinning process and therefore mitigate against the problems of warpage and breakage. However, it will be appreciated that the thickness of the moulding compound 28 will be limited at least in dependence upon the thickness of the final semiconductor package.

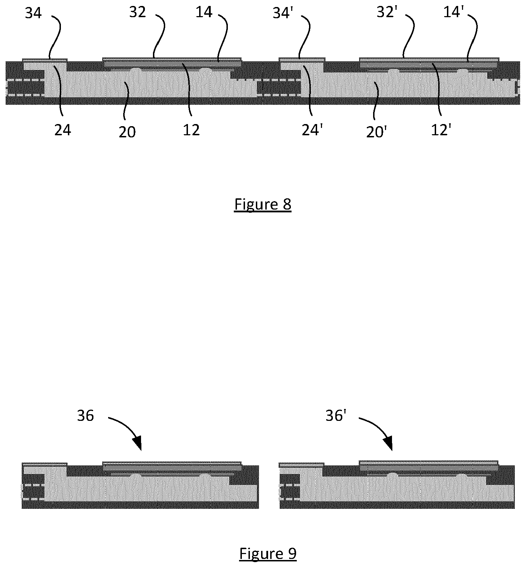

Figure 8 shows an eighth step of the manufacturing method. In the eighth step, a first plating 32 is provided to the first surface 14 of the die 12 and a second plating 34 is provided to the second connection portion 24 of the clip 20. The first and second platings 32, 34 may be formed by electroplating. The first and second platings 32, 34 act to protect the first surface 14 of the die 12 and the second connection portion 24 of the clip 20 respectively and provide additional mechanical strength to the die 12. The first and second platings 32, 34 provide ohmic connections to the die 12 and the clip 20.

Accordingly, the first and second platings may be made of a conductive material, such as metal, and in particular copper, a titanium-nickel-silver alloy, or the like. The platings 32, 34 may be upto around 8µm in thickness.

Figure 9 shows a ninth step of the manufacturing method. In the ninth step, the adjacent bodies are separated to form individual manufacturing intermediates 36, 36'. The separation process may be any suitable separation process, for example cutting or the like.

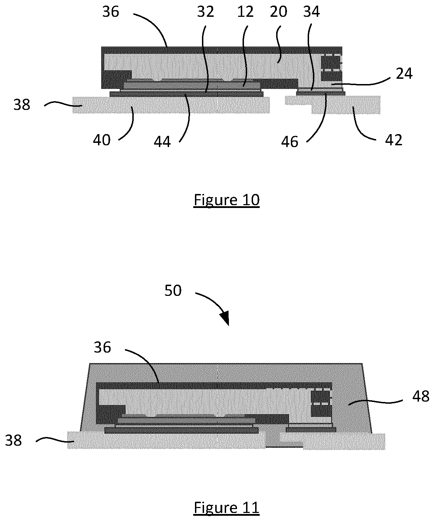

Figure 10 shows a first step in a method for manufacturing a semiconductor package using the manufacturing intermediate 36 arrived at by the manufacturing method described above in relation to Figures 1 to 9. In the first step, the manufacturing intermediate 36 and a second base frame 38 are provided. The second base frame 38 is made from metal, for example copper. The second base frame 38 comprises a first portion 40 and a second portion 42. The first portion 40 of the second base frame 38 is attached to the first plating 32 of the die 12 via a fourth patch of adhesive 44. The second portion 42 of the second base frame 38 is attached to the second plating 34 of the second connection portion 24 of the clip 20 via a fifth patch of adhesive 46. Again, the fourth and fifth patches of adhesive 44, 46 may be any suitable form of adhesive, preferably conductive adhesive, for example solder.

Whilst the above method has been illustrated with a second base frame 38 comprising only two portions, it will be appreciated that in alternative embodiments the second base frame 38 may comprise any number of portions. In particular, it will be appreciated that each portion of the second base frame 38 may correspond to a connection terminal of the semiconductor package 50 to enable the semiconductor package to be integrated into electronic circuitry. For example, the various portions of the second base frame 38 may define the drain, signal and ground terminals of the semiconductor package 50. Accordingly, each portion of the second base frame 38 may be attached to a corresponding connection portion of the clip 20.

Figure 11 shows a second step in the method for manufacturing a semiconductor package using the manufacturing intermediate 36. In the second step, the manufacturing intermediate 36 and the second base frame 38 are encapsulated by a second moulding compound 48 to form a semiconductor package 50. The second moulding compound 48 may be made from any suitable moulding compound, such as for example silicone or epoxy resin, plastic or the like. The second moulding compound 48 may be made from the same material as the first moulding compound 28, or a different material. The step of encapsulating the manufacturing intermediate 36 and the second base frame 38 in the second moulding compound 48 should leave at least part of the first portion 40 and the second portion 42 of the second base frame 38 exposed.

The semiconductor package 50 may be any suitable semiconducting device, for example a MOSFET or the like.

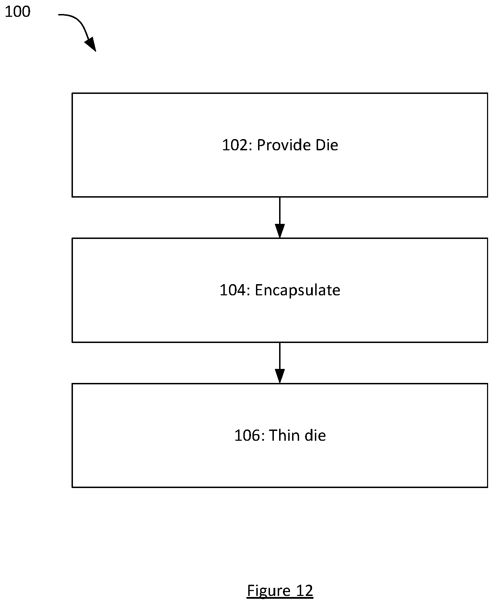

Figure 12 shows a schematic process diagram of the method of manufacturing a manufacturing intermediate described above in relation to Figures 1 to 9. The method 100 comprises at least a step 102 of providing the die 12. This is followed by a step 104 of encapsulating the die 12 within a moulding compound 28. This is in turn followed by a step 106 of thinning the die. As explained above, the moulding compound 28 provides strength to the die 12 to prevent it deforming during or after thinning, thus mitigating the problems of warpage and breakage experienced in the prior art.

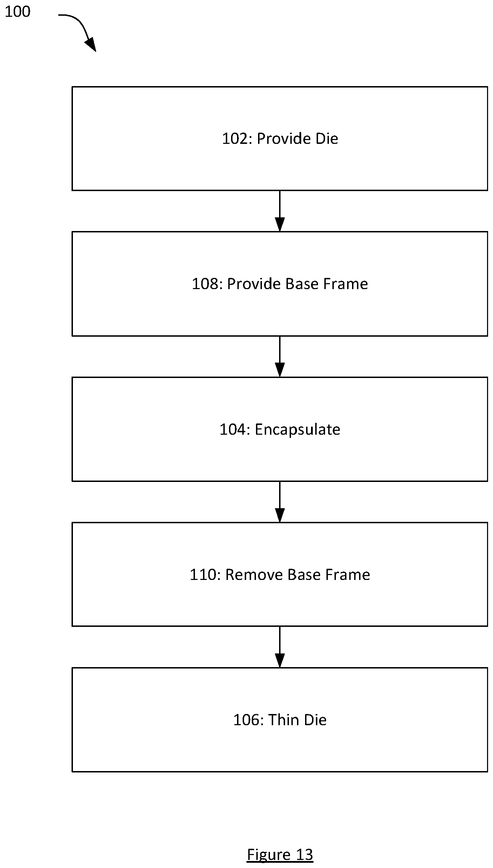

Figure 13 shows the method 100 in more detail. In particular, the method 100 may optionally further comprise, before the step 104 of encapsulation, a further step 108 of providing a base frame 2. The die 12 may be attached to the base frame 2 in the manner described above in relation to Figures 2 and 3. Additionally, the method 100 may optionally further comprise, following the step 104 of encapsulation and before the step 106 of thinning the die 12, a further step of removing the base frame 2. The base frame 2 may be removed in the manner described above in relation to Figure 7.

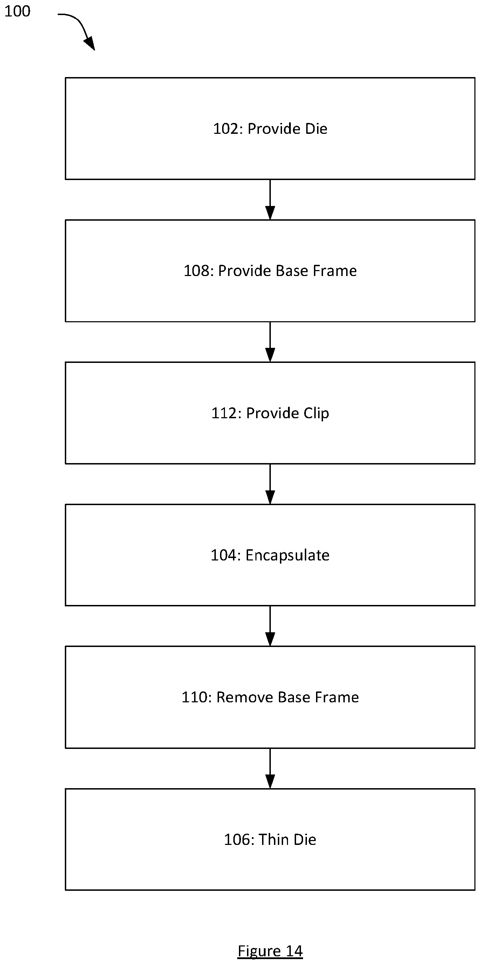

Figure 14 shows the method 100 in yet further detail. In particular, the method 100 may further comprise, following the step 108 of providing the base frame 2 and before the step 104 of encapsulation an additional step 112 of providing the clip 20. The clip 20 may be attached to the die 12 as described above in relation to Figure 5.

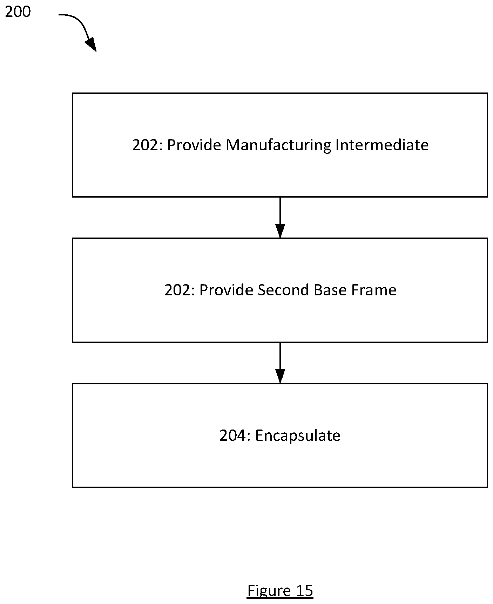

Figure 15 shows a schematic process diagram of the method of manufacturing a semiconductor package 50 described above in relation to Figures 10 and 11. In a first step 202 the method 200 comprises providing the manufacturing intermediate 36 arrived at as a result of the method 100 of manufacturing a manufacturing intermediate. In a second step 202, a second base frame 38 is provided. The second base frame 38 may be attached to the manufacturing intermediate 36 as described above in relation to

Figure 10. In a third step 204, the second base frame 38 and the manufacturing intermediate 38 are encapsulated in a second moulding compound 48, in the manner described above in relation to Figure 11.

## Claims

1. A method of manufacturing a manufacturing intermediate for a semiconductor package, the method comprising:
providing a die;
at least partially encapsulating the die within a moulding compound; and
thinning the die.

2. A method according to claim 1:
wherein the die defines a first surface and a second surface;
the method further comprising:
providing a base frame having a first surface and a second surface;
attaching the first surface of the die to the first surface of the base frame;
wherein the step of at least partially encapsulating the die within a moulding compound comprises at least partially encapsulating the base frame and the die within the moulding compound; and
removing the base frame to expose the first surface of the die.

3. A method according to claim 2:
wherein the step of at least partially encapsulating the base frame and the die within the moulding compound comprises leaving the second surface of the base frame exposed.

4. A method according to any of claims 1 to 3, wherein the step of thinning the die comprises thinning the die to at most around 100 µm, or preferably at most around 50 µm, or more preferably at most around 25 µm, or most preferably at most around 15 µm.

5. A method according to any of claims 1 to 4, wherein prior to the step of thinning the die, the die comprises a thickness of at least around 150 µm to 700 µm.

6. A method according to any of claims 1 to 5, wherein thinning the die comprises abrading the die.

7. A method according to any of claims 2 to 6, comprising:
providing a clip having a first connection portion and a second connection portion;
before the step of at least partially encapsulating the base frame and the die within a moulding compound:
attaching the first connection portion of the clip to the second surface of the die; and
attaching the second connection portion of the clip to the first surface of the base frame; and
during the step of encapsulating the base frame and the die within a moulding compound:
encapsulating the clip within the moulding compound.

8. A method according to claim 7, further comprising:
thinning the second connection portion of the clip.

9. A method according to claim 8, further comprising:
providing a first plating to the first surface of the die; and
providing a second plating to the second connection portion of the clip.

10. A method of manufacturing a semiconductor package comprising:
providing a manufacturing intermediate according to claim 9;
providing a second base frame having a first portion and a second portion;
attaching the first portion of the second base frame to the first plating; and
attaching the second portion of the second base frame to the second plating.

11. A method according to claim 10, further comprising:
at least partially encapsulating the manufacturing intermediate, first plating, second plating, and second base frame within a second moulding compound.

12. A manufacturing intermediate for a semiconductor package, comprising:
a die having a first surface and a second surface; and
a moulding encapsulating the die;
wherein the first surface of the die is exposed.

13. A manufacturing intermediate according to claim 12, wherein the die comprises a thickness of at most around 100 µm, or preferably at most around 50 µm, or more preferably at most around 25 µm, or most preferably at most around 15 µm.

14. A manufacturing intermediate according to claim 12 or 13, further comprising:
a clip having a first connection portion and a second connection portion;
wherein:
the clip is encapsulated within the moulding compound;
the first connection portion is attached to the second surface of the die; and
the second connection portion is exposed.

15. A semiconductor package comprising:
the manufacturing intermediate of claim 13 or 14;
a first plating attached to the first surface of the die;
a second plating attached to the second connection portion of the clip;
a base frame comprising a first portion attached to the first plating and a second portion attached to the second plating; and
a second moulding encapsulating the manufacturing intermediate, first plating, second plating, and base frame.
